# EUROPEAN PATENT APPLICATION

(11) **EP 3 726 230 A1**
(43) Date of publication of application: **21.10.2020**
(21) Application number: 19169348.0
(22) Date of filing: 15.04.2019
(51) Int. Cl.: G01R 31/02, G01R 31/06

(54) **SHORT CIRCUIT DETECTION OF AN ELECTROMAGNETIC INDUCTION COIL**

(71) Applicant: Prodrive Technologies B.V., 5692 EM Son (NL)
(72) Inventor: Ben, BRON, NL-5692 EM Son (NL); Danny, VOS, NL-5692 EM Son (NL)
(74) Representative: Pronovem

(57) **Abstract**

Apparatus (10, 20), comprising at least one electromagnetic induction coil (Lp1-Lpx), and a detection device (12, 22) for detecting a short circuit in the at least one electromagnetic induction coil. The detection device comprises a detection coil (Ls1-Lsx) independent of the at least one electromagnetic induction coil and a detection circuit (121) coupled to the detection coil. The detection coil (Ls1-Lsx) is arranged such that the detection coil is inductively coupled to the at least one electromagnetic induction coil (Lp1-Lpx). The detection circuit (121) is configured to drive the detection coil (Ls1-Lsx) in order to induce an electric current in the at least one electromagnetic induction coil (Lp1-Lpx). The detection circuit is configured to determine a frequency of an electric signal induced in the detection coil (Ls1-Lsx) by the electric current.

## Description

### Technical field

The present invention is related to an apparatus comprising a short circuit detection device for detecting short circuit of an electromagnetic induction coil. The present invention can be used in basically any application such as for example motors (rotating and linear), transformers or inductors.

### Background art

US 3863109 describes a method of detecting a short circuit by means of an additional sensing coil or hall device. A short circuit of the high voltage side is detected by a separate low voltage side by using a secondary coil or hall device for the short circuit detection. A disadvantage is that the primary coil needs to be active/carrying a current in order to detect a short circuit with the secondary coil or hall device.

JP2013061310A and JP2011252752A describe a method of detecting a short circuit in a transformer by measuring the gain of the transfer function of the secondary winding at a single frequency, located near the first resonance frequency of the transformer, while the primary winding of the transformer is open. A disadvantage of this approach is that it requires knowledge of the resonance frequency of the transformer. An additional disadvantage is that the transfer function near the resonance frequency of the transformer is heavily influenced by parasitic capacitances between windings.

### Summary of the invention

In some critical applications, it is desired to be able to detect a short circuit of an electromagnetic induction coil without driving the coil directly. It is therefore an aim of the present invention to provide an apparatus comprising a detection device for detecting a short circuit of an electromagnetic induction coil of the apparatus which allows for safer operation of the apparatus.

It is further an aim of the present invention to provide an apparatus for detecting a short circuit of an electromagnetic induction coil with reduced complexity and/or less hardware. It is also an aim to provide such apparatuses which allow for detecting a short circuit of an electromagnetic induction coil with greater reliability, and which possibly allow for discriminating between different kinds of short circuits.

According to the present invention, there is therefore provided an apparatus as set out in the appended claims. The apparatus comprises at least one electromagnetic induction coil, and a detection device for detecting a short circuit in the at least one electromagnetic induction coil. The detection device comprises a detection coil independent of the at least one electromagnetic induction coil and a detection circuit coupled to the detection coil. The detection coil is arranged such that the detection coil is inductively coupled to the at least one electromagnetic induction coil. Advantageously, the detection coil is arranged in such a way with respect to the at least one electromagnetic induction coil, that a short circuit in the at least one electromagnetic induction coil causes a change in inductance of the detection coil. The detection circuit is configured to drive the detection coil in order to induce an electric current in the at least one electromagnetic induction coil.

According to the invention, the principle of the detection is based on a change in inductance of the detection coil due to a short circuit in the at least one electromagnetic induction coil. Depending on the number of turns that are forming the short circuit, the change in inductance will differ, advantageously giving the possibility to distinguish between different types of short circuit by the detection device.

With the above detection circuit, it becomes possible to detect a short circuit while the at least one electromagnetic induction coil is disabled and not operating. This increases safety. It is hence not required that the at least one electromagnetic induction coil must be driven in order to be able to detect a short circuit therein, since both electromagnetic induction coil and detection coil have independent circuits. Advantageously, the at least one electromagnetic induction coil is disconnected from power supply, and advantageously forms an open circuit during detection by the detection circuit. The detection circuit is advantageously configured to detect a change from the open circuited configuration of the at least one electromagnetic induction coil to a short circuit of one or more windings of the at least one electromagnetic induction coil.

A second advantage of having a separate circuit comprising the detection coil for the detection of the short circuit in the at least one electromagnetic induction coil, is the ability to separate between high voltage and low voltage. The detection circuit can be powered with a low voltage source and advantageously does not need to cross a high voltage barrier in order to detect a short circuit in the at least one (high voltage) electromagnetic induction coil, which further increases safety and decreases cost since the detection circuit can be made from low voltage components. The at least one electromagnetic induction coil and the detection coil can be seen as an isolated transformer, and the detection coil and the detection circuit can be completely situated at a low voltage side.

Advantageously, a winding ratio between the at least one electromagnetic induction coil and the detection coil is selected such that a voltage induced in the detection coil during operation of the at least one electromagnetic induction coil is 60 V or less. By so doing, the detection device remains at low voltage without risk of hazard or injury.

Advantageously, the detection circuit is configured to sense a signal representative of a magnetic flux induced in the detection coil due to the electric current induced in the at least one electromagnetic induction coil. The detection circuit can be implemented in different ways and is advantageously able to detect complete and/or partial short circuits on the at least one electromagnetic induction coil.

According to the present invention, the detection circuit is configured to determine a frequency of a second electric signal induced in the detection coil following application of a first electric signal to the detection coil. Application of the first electric signal induces a current in the electromagnetic induction coil. Either the electromagnetic induction coil, or the detection coil, or both can be formed as resonant tank circuits, due to provision of a physical capacitor and/or the presence of parasitic capacitances. This causes an oscillating current in the detection coil, the frequency of which can easily and reliably be detected. Such frequency detection is more precise and requires less hardware compared to amplitude based measurements as in the prior art. By way of example, amplitude based measurement would require the use of an A/D converter, and the use of an A/D converter can be dispensed with in frequency based measurements.

Further advantageous embodiments are set out in the dependent claims.

A method of detecting a short circuit in an electromagnetic induction coil by means of apparatuses according to the present invention is described herein as well. The method comprises operating the apparatus as described herein.

### Brief description of the figures

Aspects of the invention will now be described in more detail with reference to the appended drawings, wherein same reference numerals illustrate same features and wherein:
Figure 1 represents an electrical scheme of an apparatus comprising an electromagnetic induction coil and a detection circuit;
Figure 2 represents a graph showing the voltage at node x in Fig. 1 in various circumstances (with or without short circuit);
Figure 3 represents an electrical scheme of an apparatus according to the present invention comprising an electromagnetic induction coil coupled in a resonant circuit and a detection circuit;
Figure 4 represents a graph showing the voltage at node y in Fig. 3 in various circumstances (with or without short circuit).
Figures 5A-B represent possible layouts of the detection coil and electromagnetic induction coil according to the present invention.

### Description of embodiments

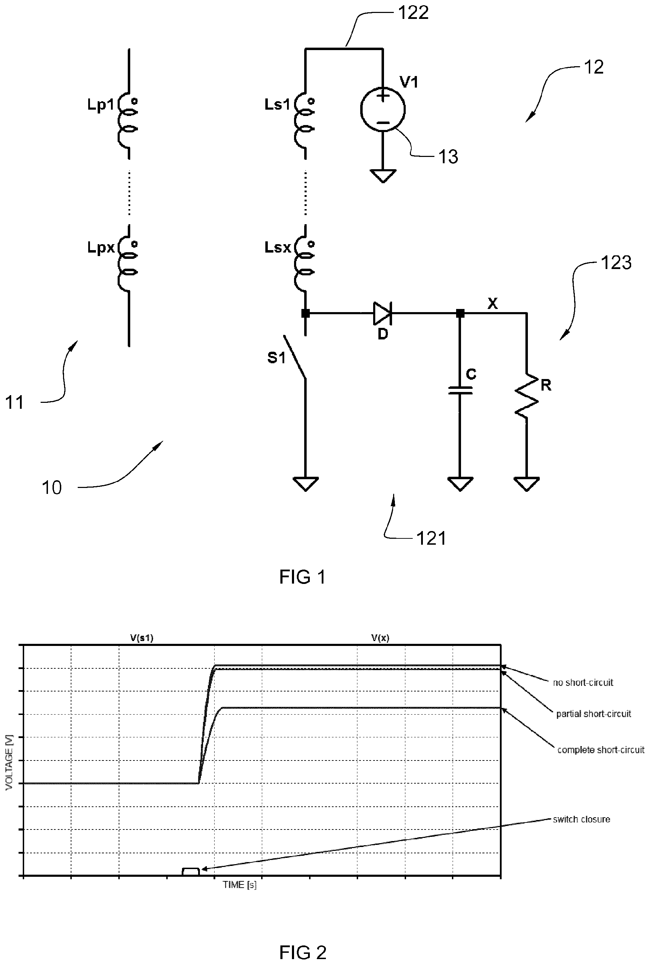

An example implementation of an apparatus for detecting a short circuit is shown in Fig. 1. Apparatus 10 comprises an application part 11 comprising an electromagnetic induction coil depicted as multiple coil windings Lp1-Lpx connected in series. The application part 11 can comprise one or more electromagnetic induction coils as required for the application and these will henceforth be referred to as application coil(s). Lp1-Lpx can e.g. be stator windings of an electric motor, a transformer, or any other device making use of electromagnetic induction coils. The application part 11 can be coupled in dedicated operating circuits as known in the art for the particular purpose. By way of example, the application part can be connected to a (high voltage) power supply. There is no need that the application part 11 be coupled in a circuit dedicated to short circuit detection, since this is taken care of by a detection device 12.

Detection device 12 comprises a detection coil having one or more windings Ls1-Lsx connected in series coupled to a detection circuit 121. The detection circuit 121 is configured to drive the detection coil Ls1-Lsx such that a current flows through the detection coil Ls1-Lsx. The current through the detection coil Ls1-Lsx induces a magnetic flux in the application coil Lp1-Lpx which in turn causes a current to flow in the application coil Lp1-Lpx. To this end, the detection coil Ls1-Lsx is advantageously arranged such that it is magnetically (inductively) coupled to the application coil(s) Lp1-Lpx in order that a current flowing through the application coil(s) induces a magnetic flux in the detection coil that can be measured.

It will be convenient to note that the number of turns or windings of the detection coil Ls1-Lsx can be selected as desired, e.g. to obtain a desired sensitivity of the detection circuit. Advantageously, the detection coil Ls1-Lsx is arranged such that an induced voltage in the detection circuit will be substantially lower than a voltage applied to the application coil during use (operation). This can be obtained by proper selection of the location where the detection coil is placed with respect to the application coil, or by proper selection of the number of windings of the detection coil in relation to the number of windings of the application coil.

Detection circuit 121 comprises a first circuit 122 referred to as driving circuit and a second circuit 123 referred to as measuring circuit. The driving circuit 122 comprises a switch S1 coupled in series with the detection coil Ls1-Lsx and a power supply 13. The measuring circuit 123 is coupled to the driving circuit 122 in order to measure an electric signal, such as a voltage, in the driving circuit 122.

By closing switch S1, in particular when the application coil is not in operating state, e.g. it is open circuited, a voltage step is applied over the detection coil Ls1 -Lsx. This causes a current to flow through the detection coil Ls1 -Lsx, in turn inducing a magnetic flux and related current in the application coil Lp1-Lpx. When the switch S1 is opened, the formerly induced current in the application coil Lp1-Lpx will induce a magnetic flux in the detection coil Ls1-Lsx which is measured through measuring circuit 123. Measuring circuit 123 can be configured to measure the complex impedance, e.g. by evaluating the current through the detection coil Ls1-Lsx with switch S1 open.

Any appropriate voltage step can be contemplated. Alternatively, a pulse of given duration can be applied to switch S1, and the stored energy in the application coil Lp1-Lpx and detection coil Ls1-Lsx can be evaluated by measuring the voltage at node x. A complete or partial-short circuit of the application coil Lp1-Lpx will result in less stored energy and hence a lowered voltage at node x, as visualized in the graph of Fig. 2.

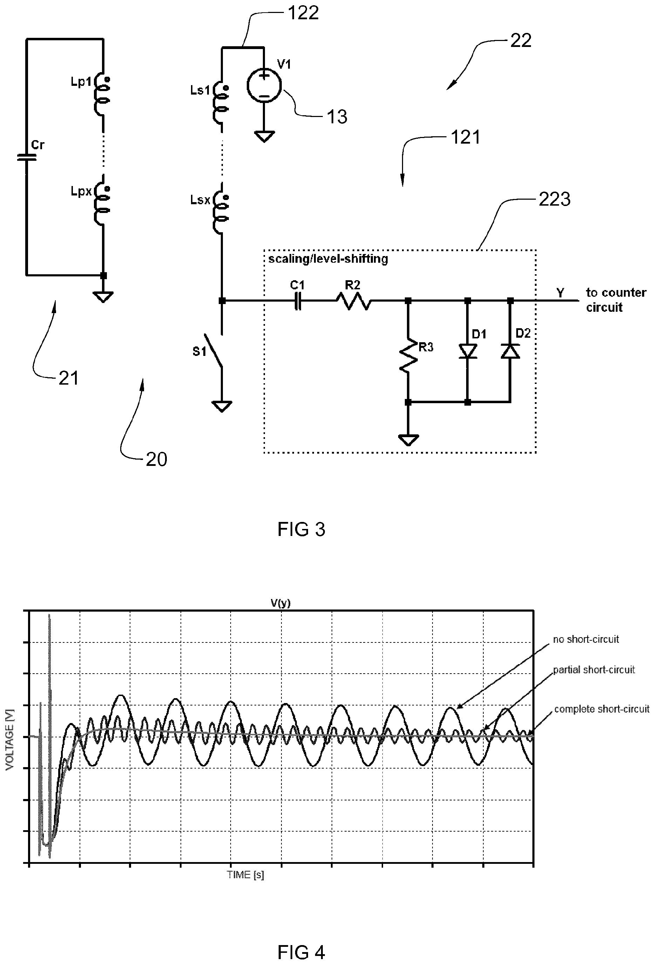

According to the present invention, the apparatus 10 of Fig. 1 is further improved as shown in Fig. 3. Referring to Fig. 3, apparatus 20 differs from apparatus 10 in that a capacitor Cr is added across the application coil Lp1-Lpx. Alternatively or in addition, a capacitor can be added across the detection coil Ls1-Lsx. This results in a resonant circuit being formed which advantageously transforms the impedance measurement problem of Fig. 1 into a frequency measurement problem, which improves the sensitivity and is easier to implement in digital logic. A scaling / level shifting network can be used as measuring circuit 223, which translates the voltages at node y to a level at which the timing of the zero crossings can be easily detected by a digital circuit. The graph of Fig. 4 shows the voltage signals at node y for same circumstances as in Fig. 2 (same voltage step applied).

In some cases, the circuit of the application coil can comprise substantial parasitic capacitances, allowing to exploit these parasitic capacitances to form a resonant circuit. In these cases, the parasitic capacitances may act in replacement of the capacitor Cr, and capacitor Cr may be omitted from the circuit of Fig. 3.

During operation of the detection device 12, 22, the application coil Lp1-Lpx are advantageously not driven, e.g. they are advantageously disconnected from a power source. The detection device 12, 22 can furthermore comprise a computing and/or control unit configured to compare the measurement (of the impedance or the frequency) with a reference value representative of a no short-circuit condition of the application coil Lp1-Lpx. The reference value can be obtained by calibration or can be based on previous measurements. The control unit can furthermore be configured to emit a signal when a fault state of the at least one electromagnetic induction coil is detected. The signal can be operable, e.g. through appropriate relay, etc., to render the application coil inoperative.

The additional capacitor Cr can advantageously be selected with tight tolerances, instead of only relying on parasitic capacitances. Using such a circuit can significantly improve the reproducibility of the measurements and reduce inter-circuit variability. This offers the possibility to use pre-calculated limits for the no short-circuit condition.

The power supply 13 can be a low voltage power supply, operating at a safe voltage of 60 V DC or less, e.g. at 12 V DC. The detection circuit 121 should be able to withstand the voltage induced in the detection coil Ls1-Lsx while switch S1 is open and the application coil Lp1-Lpx is operating. This will of course depend on the particular application. One possibility is to increase the impedance in detection circuit 121 to appropriate values. Another possibility is to select the number of turns of the detection coil Ls1-Lsx in relation to the number of turns of the application coil Lp1-Lpx in order to mitigate the voltage induced in the detection coil Ls1-Lsx. This may also avoid interference with operation of the application coil Lp1-Lpx.

It will be convenient to note that during closure of switch S1, the circuit in which the application coil Lp1-Lpx is coupled can be open, e.g. the detection device 12, 22 is able to discriminate between a condition in which the application coil is open circuited (disabled) and a faulty condition in which there is a short circuit between one or more windings or turns of the application coil Lp1-Lpx.

During normal operation of the application part 11, the switch S1 advantageously remains open, and detection circuit 121 advantageously is not operated. By appropriate selection of the value of the impedance of the detection circuit, the current through the detection coil Ls1-Lsx can be minimized during operation of the application coil Lp1-Lpx.

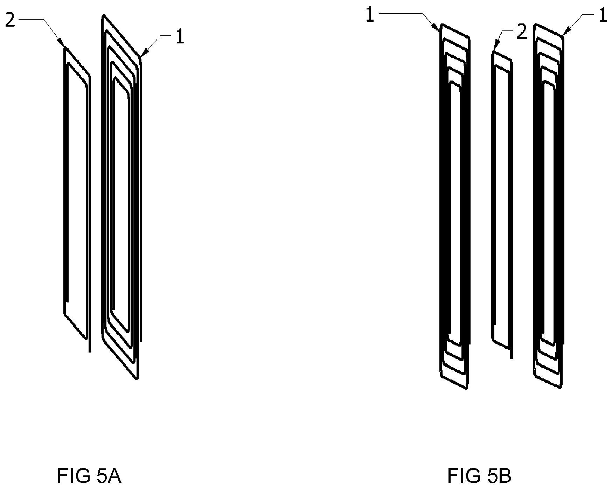

Referring to Figs. 5A and 5B, possible arrangements for the application coil 1 and the detection coil 2 are presented. Either one, or both the application coil 1 and the detection coil 2 can be formed of planar wound coils, i.e. comprising substantially coplanar windings (all windings arranged in substantially a same plane). The application coil 1 and the detection coil 2 can be arranged with their winding planes parallel to each other.

In Fig. 5B, the detection coil 2 is interposed between two application coils 1. The detection coil 2 can be arranged to detect a short circuit in both application coils.

Apparatuses according to the invention can refer to electric motors, such as rotary motors, with the application coil referring to e.g. a stator coil. Alternatively, the electric motor can be a linear motor, such as those used as actuators in magnetic lift systems. The linear motor can comprise stator coils and permanent magnet moving units. In the latter case, the application coil can refer to the stator coil, and the detection device is configured to detect a short circuit in the stator coil.

The detection device can be configured to initiate a detection cycle at regular intervals in order to test the integrity of the application coil. By way of example, in the magnetic lift systems referred to above, some branches of the lift path may not be used frequently, and a regular detection of short circuits in the stator coils is useful while the path is not being used.

## Claims

1. Apparatus (20), comprising:
at least one electromagnetic induction coil (Lp1-Lpx), and
a detection device (22) for detecting a short circuit in the at least one electromagnetic induction coil,
wherein the detection device comprises a detection coil (Ls1-Lsx) independent of the at least one electromagnetic induction coil and a detection circuit (121) coupled to the detection coil,
wherein the detection coil (Ls1-Lsx) is arranged such that the detection coil is inductively coupled to the at least one electromagnetic induction coil (Lp1-Lpx), and
wherein the detection circuit (121) is configured to:
connect the detection coil (Ls1-Lsx) to a power supply (13) and apply a first electric signal to the detection coil in order to induce an electric current in the at least one electromagnetic induction coil (Lp1-Lpx), and
disconnect the detection coil (Ls1-Lsx) from the power supply (13), **characterised in that** the detection circuit is configured to determine a frequency of a second electric signal induced in the detection coil (Ls1-Lsx) following the first electric signal.

2. Apparatus of claim 1, wherein the detection circuit (121) is configured to sense a signal representative of a magnetic flux induced in the detection coil (Ls1-Lsx) due to the electric current induced in the at least one electromagnetic induction coil (Lp1-Lpx).

3. Apparatus of claim 1 or 2, wherein the at least one electromagnetic induction coil (Lp1-Lpx) and the detection coil (Ls1-Lsx) are electrically isolated.

4. Apparatus of any one of the preceding claims, comprising a controller configured to render the at least one electromagnetic induction coil inoperative in response to the detection device (12, 22) determining a fault state of the at least one electromagnetic induction coil (Lp1-Lpx).

5. Apparatus of any one of the preceding claims, configured to operate the detection circuit (121) while the at least one electromagnetic induction coil (Lp1-Lpx) is in an inactive state.

6. Apparatus of claim 5, comprising a first power supply configured to be connected to the at least one electromagnetic induction coil (Lp1-Lpx), a second power supply (13) configured to be connected to the detection coil (Ls1-Lsx), and a controller configured to connect the detection coil to the second power supply while the at least one electromagnetic induction coil is disconnected from the first power supply.

7. Apparatus of claim 6, comprising a first capacitor (Cr) coupled to the at least one electromagnetic induction coil (Lp1-Lpx) forming a resonant electromagnetic induction circuit.

8. Apparatus of claim 6 or 7, wherein a voltage level of the first power supply is higher than a voltage level of the second power supply, preferably at least 50 V, more preferably 100 V higher, even more preferably at least 150 V higher.

9. Apparatus of any one of the claims 6 to 8, wherein a voltage level of the second power supply (13) is 60 V or less, preferably between 5 V and 50 V.

10. Apparatus of any one of the preceding claims, wherein the first electric signal is a voltage step.

11. Apparatus of any one of the preceding claims, wherein the first electric signal is an impulse signal.

12. Apparatus of any one of the preceding claims, wherein the detection circuit (121) comprises a second capacitor (C1) which is coupled to the detection coil forming a resonant detection circuit.

13. Apparatus of any one of the preceding claims, wherein the detection device (12, 22) comprises a printed circuit board and the detection coil (Ls1-Lsx) is formed by a conductive trace on the printed circuit board.

14. Apparatus of any one of the preceding claims, wherein the at least one electromagnetic induction coil (Lp1-Lpx) is a coil of an electric motor.

15. Apparatus of any one of the claims 1 to 15, wherein the at least one electromagnetic induction coil (Lp1-Lpx) is a coil of a transformer.
